Europäisches Patentamt

European Patent Office

Office européen des brevets

(11) Publication number: **0 047 099**
**A2**

## (12) EUROPEAN PATENT APPLICATION

(21) Application number: **81303772.8**

(22) Date of filing: **19.08.81**

(51) Int. Cl.³: **H 01 L 25/04**
**H 01 L 23/36, H 01 L 23/54**

(30) Priority: **28.08.80 GB 8027867**

(43) Date of publication of application:
**10.03.82 Bulletin 82/10**

(84) Designated Contracting States:
**BE DE FR GB IT SE**

(71) Applicant: **LUCAS INDUSTRIES LIMITED**
**Great King Street**
**Birmingham, B19 2XF(GB)**

(72) Inventor: **Lowe, Ronald Charles**
**Henfaes Uchaf**
**Cynwyd Nr. Corwen Clwyd(GB)**

(74) Representative: **Carpenter, David et al,**
**MARKS & CLERK Alpha Tower ATV Centre**
**Birmingham B1 1TT(GB)**

(54) Full wave rectifier assembly.

(57) A three phase full wave rectifier assembly wherein the six diodes (22-27) from which the rectified output is obtained are all supported on a single heat sink member (11) and are all in heat exchange relationship therewith.

Fig.1

Croydon Printing Company Ltd.

This invention relates to a three phase full wave rectifier assembly particularly, but not exclusively, intended for use in a road vehicle alternator.

A three phase full wave rectifier of necessity includes six diodes. In a known rectifier assembly the six semi-conductor diodes are arranged in two sets of three, the three diodes of one set being mounted on a first common heat sink plate and the diodes of the other set being similarly mounted on a second common heat sink plate. Generally the heat sink plates are electrically conductive and the diodes of each set have one terminal electrically connected to their respective plate. The one set will have its anodes connected to the first plate while the other set will have its cathodes connected to the second plate and the first and second plates will thus be negative and positive terminal plates of the assembly. Such known alternators are electrically and thermally efficient but are bulky and expensive to produce. These disadvantages are increased where, as is often the case in road vehicle applications, a third set of three diodes is required to provide a rectified electrical supply to the field system of an alternator. The third set will be mounted on a third plate thus adding materially to the bulk, complexity and expense of the assembly. It is an object of the present invention to provide a three phase full wave rectifier assembly wherein these problems are minimised.

In a three phase full wave rectifier assembly according to the present invention the six semi-conductor diodes, from which the full wave rectified output is obtained in use, are all supported on, and in heat exchange relationship with, a single common heat sink member.

Preferably first and second conductive areas are provided on said heat sink member, said areas being electrically isolated from each other, the diodes of one set of three of said six diodes each having the same one of its two terminals electrically connected to said first conductive area and the diodes of a second set, comprising the remaining three of said six diodes, each having their other terminal electrically connected to said second area.

Desirably said member is provided with third, fourth and fifth conductive areas electrically isolated from each other and from said first and second conductive areas, said diodes of said one set are positioned on said first conductive area and have their said one terminals conductively bonded directly to said first conductive area, and said diodes of said second set are each positioned on a respective one of said third, fourth and fifth conductive areas with their one terminal conductively bonded directly thereto, said other terminals of said diodes of said second set being electrically connected by way of respective conductive links to said second conductive area, and, in use, the three phases of the supply to be rectified are applied respectively to the other terminal of a first diode of said one set and said third area, the other terminal of a second diode of said one set and the fourth area, and to the other terminal of the third diode of said one set and the fifth area, whereby a rectified output appears across said first and second areas.

Alternatively said diodes of said first set are arranged on said first conductive area with their said one terminals directly bonded thereto, said diodes of said second set are arranged on said second conductive area with their said other terminals bonded directly thereto and, in use, the three phases of the supply to be rectified are applied respectively to the other terminal of a first diode of said one set and the one terminal of a first diode of said second set, to the other terminal of a second diode of said one set and the one terminal of a second diode of said second set, and to the other terminal of the third diode of said one set and the one terminal of the third diode of the second set, whereby a rectified output appears across said first and second conductive areas.

Desirably the heat sink member is provided with a sixth conductive area and said member supports and is in heat exchange relationship with a third set of three diodes, the diodes of said third set each having a common one of their two terminals electrically connected to said sixth conductive area.

Preferably said diodes of said third set are arranged on said sixth area and have their said one terminals bonded directly to said sixth area, the other terminals of the diodes of the third set, in use, having respectively phases of the supply being rectified by said first and second sets of diodes, applied thereto.

Conveniently said heat sink member is formed from electrically insulating material and said conductive areas are layers of conductive material supported by said member.

Preferably said heat sink member is formed from electrically conductive material and carries a layer of electrically insulating material on which said conductive areas are provided, said areas being layers of conductive material on said layer of insulating material and said layers being supported by said member.

Alternatively said heat sink member is formed from electrically conductive material and an exposed surface region of said member defines one of said conductive areas, the other conductive areas being defined by layers of conductive material on a layer of insulating material carried by said member, said layers being supported by said member.

Desirably said layers of conductive material are provided on said member by a printed circuit technique.

Conveniently said heat sink member is tubular and said conductive areas are on the exterior of the member.

One example of the invention is illustrated in the accompanying drawings, wherein,

Figure 1 is a plan view of a three phase full wave rectifier assembly;

Figure 2 is a sectional view on the line 2-2 in Figure 1;

Figure 3 is a perspective view of part of the assembly shown in Figures 1 and 2; and

Figure 4 is a circuit diagram of the assembly of Figure 1.

Referring to the drawings, the three phase full wave rectifier assembly includes a tubular copper heat sink member 11 of square cross-section coated over part of its external surface with a layer 12 of electrically insulating material. The material of the layer 12 is conveniently a glass or ceramic material of an electrically insulating nature, and is applied to the appropriate surface region of the member 11 by screen printing. The glass or ceramic material in finely divided form is carried in a screen printing ink and is applied by the screen printing technique in a layer of 20 to 25 microns thickness. The member 11 is then fired in an oven or furnace at a temperature of approximately 800°C to fuse the finely divided glass or ceramic material and to drive off the carrier.

When suitably cool the member 11 now carrying the fused layer 12 is subject to a further screen printing operation during which a conductive printing ink is applied to the layer 12 in a predetermined pattern. The member 12 is then fired at approximately 500°C to cause the conductive particles to fuse together, and to bond to the layer 12 in the printed pattern. This technique of producing conductive layers on an insulating layer is known, and is a technique frequently used for thick film printed circuits, that is to say the printed circuits where the substrate of the circuit is a heat resistant material, for example a ceramic tile.

The conductive pattern printed onto the layer 12 occupies one face of the member 11 and spreads over onto the oppositely presented adjacent faces. The pattern consists of nine separate conductive areas indicated in the drawings by the reference numerals 13, 14, 15, 16, 17, 18, 19, 20, and 21 respectively.

The areas 13 and 14 each comprise a broad band extending transversely across the top face 11a of the member 11, and extending over onto the adjacent oppositely presented faces 11b, 11c of the member 11. Integral with the broad band of each of the areas 13, 14 is an integral strip 13a, 14a extending longitudinally of the top face 11a. The two strips 13a, 14a are parallel to one another, and are spaced transversely of the top face 11a. The area 21 includes an integral strip 21a which extends parallel to the strips 13a, 14a and lies between them. The strip 21a is connected to a broad band which extends across part of the face 11a and onto the face 11b.

The areas 15, 16 and 17 are similar to one another, and extend partly on the face 11a and partly on the face 11c, while the areas 18, 19 and 20 are aligned transversely of the face 11a with the areas 17, 16, 15, respectively and extend from the face 11a onto the face 11b.

The assembly further includes nine semi-conductor diodes. The nine diodes numbered 22, 23, 24, 25, 26, 27, 28, 29, and 31 are all of the same type, being epitaxial semi-conductor diodes. Although the diodes are all of the same type, the three numbered 28, 29, and 31 are of a smaller size than the remaining six. The semi-conductor diodes are each of the type which has a mounting face whereby the diode can be mounted on a planar surface, the mounting face containing the cathode of the diode. The intention is that mounting the diode by means of solder or the like to a conductive surface makes the electrical connection to the cathode. The anode of each of the diodes is such that connection is to be made thereto by means of a conductive wire. It will be apparent therefore that it is extremely desirable to use a physical arrangement wherein each of the nine diodes can be mounted by means of its cathode face. Thus, the three small diodes 28, 29, 31 are arranged spaced apart along the length of the strip 21a, the three of the larger diodes 25, 26 and 27 are spaced apart along the length of the strip 14a, aligned with the diodes 28, 29, 31 respectively in a direction transverse to the strips 14a, 21a, and aligned with the other diodes 22, 23, 24 which are arranged on the conductive areas 15, 16, 17 respectively.

Prior to positioning the diodes on their respective conductive areas, the conductive areas are treated to produce gold bonding pads upon which the semi-conductor diodes are mounted. The gold bonding pads are printed onto the appropriate part of the conductive areas using a screen printing ink containing gold. The gold ink is dried and fired at 500°C to 600°C prior to positioning the semi-conductor diodes. After positioning of the semi-conductor diodes, the assembly is heated in an oven to 450°C whereupon the diodes are bonded to the conductive areas by the gold, the bonding being known as a gold/silicon eutectic bond. This technique is a known semi-conductor mounting technique.

It will be recognised that after the firing to produce the gold/silicon eutectic bond an electrical connection exists between the cathode of each of the diodes and its respective conductive area. During their manufacture the semi-conductor diodes are each formed on their anode surface with a layer of aluminium to facilitate the subsequent making of an electrical connection thereto. Links 33, 34 and 35 connect the strip 13a respectively with the aluminium coated anode surfaces of the diodes 22, 23 and 24. A link 36 electrically interconnects the aluminium coated anode surface of the diode 31, the aluminium coated anode surface of the diode 25 and the conductive area 18. A link 37 electrically interconnects the aluminium coated anode surface of the diode 29, the aluminium coated anode surface of the diode 26 and the conductive area 19. A link 38 electrically interconnects the aluminium coated anode surface of the diode 28, the aluminium coated anode surface of the diode 27 and the conductive area 20. The links 33 and 38 are formed of aluminium wire and are attached to the respective parts by ultrasonic welding.

In order to complete the assembly of the full wave rectifier the face 11a of the assembly is provided with a layer of encapsulant whereby a protective coating is provided over all of the semi-conductor diodes, the conductive links, and the conductive areas on the face 11a. The conductive areas on the faces 11b and 11c are left clear of encapsulant to facilitate the making of electrical connections to the assembly. The conductive areas on the faces 11b and 11c constitute the terminals of the full wave rectifier assembly.

In use the exposed regions of the areas 13, 14 and 21 are output terminals of the assembly, and the exposed regions of the areas 15 and 20, 16 and 19, and 17 and 18, constitute input terminals connected in use to the phases
of the supply to be rectified. Thus of the three phases
a first phase will be connected to the areas 15 and 20, a
second phase will be connected to the areas 16 and 19, and
a third phase will be connected to the areas 17 and 18.
Although these areas are electrically insulated from
one another they are intended to be electrically interconnected in pairs in use.

In order to facilitate the making of electrical connections to the device many alternative terminal arrangements
are possible. However, a convenient terminal arrangement
comprises a U-shaped metal clip formed from strip metal,
the two parallel limbs of the U-shaped clip being arranged
to receive the assembly between them. A connecting lead
is electrically and physically connected to the clip at its
base.

Thus a first U-shaped clip carrying the positive output lead is engaged with the assembly adjacent one end and
makes electrical connection to the exposed regions of the
strip 14. A second clip connected to the first phase of
the supply to be rectified straddles the assembly to make
electrical connection with the areas 15 and 20, a third
clip connected to the second phase of the supply engages
the areas 16 and 19, a fourth clip connected to the third
phase of the supply to be rectified engages the areas 17
and 18, a fifth clip carrying a positive output lead engages the exposed region of areas 21 and on the face 11c
of the assembly engages an insulating area. Lastly, a sixth
clip carrying the negative output lead engages the exposed
regions of area 13. When the three phase alternating supply
is applied to the second, third and fourth clips a rectified
output voltage appears between the first and sixth clips
and between the fifth and sixth clips.

It will be recognised that if it is chosen to produce the assembly with semi-conductor diodes where either the anode face or the cathode face can be connected to a flat conductive area then the assembly described above can be modified in that for example the three diodes connected to the areas 15, 16, and 17 can be replaced by diodes having their anode faces capable of connection to a conductive area, in which case the anode faces of the three replacement diodes would be secured to the strip 13a. Only three conductive links would then be required, the first conductive link electrically interconnecting the area 15, the exposed cathode of the diode replacing diode 22, the anode of diode 28, the anode of diode 27, and the area 20. Similarly, the second link would electrically interconnect the areas 16, the exposed cathode of the diode replacing the diode 23, the exposed anode of diode 29, the anode of diode 26, and the area 19, and lastly the third link would similarly interconnect the area 17, the exposed cathode of the diode replacing diode 24, the anode of diode 31, and anode of diode 25, and the area 18. It will be recognised that in such an arrangement if required the areas 15, 16, 17 or alternatively the areas 18, 19, 20 could be dispensed with. However, it is preferred to retain these areas firstly in order to provide a basic construction of heat sink, insulating layer, and conductive areas common to that required of the first described example, and secondly in that oppositely presented conductive areas are convenient for use in conjunction with U-shaped terminal clips.

It will further be recognised that since the member 11 is formed from conductive material then if desired it would be possible to dispense with one of the conductive areas, leaving in its place an equivalently shaped aperture in the insulating layer 12. Through this aperture the conductive material of the member 11 would be exposed, and the exposed conductive area would fulfil the same function as the printed area it replaces.

Furthermore it will be recognised that it is not essential for the member 11 to be formed from electrically conductive material. However, the primary requirement of the member 11 is that it should have good heat sink capabilities, and therefore it is probable that it will always be preferable to make the member 11 from a metal having good thermal conductivity. Notwithstanding this, if an insulating material of equivalent thermal conductivity is available then such material could be used to form the member 11, in which case there may be no need to provide the insulating layer 12. It will however be necessary to ensure that the material chosen for member 11 will adequately support and retain the conductive areas.

It will be noted that the member 11 is of rectangular tubular form, and it is thought that this configuration is the most efficient compromise between simplicity of assembly, and maximum surface area for a given mass of metal required to form the heat sink. However, it is to be understood that other tubular forms can be used if desired, and indeed forms other than tubular can be provided. For example it would be possible, and in some instances preferable, to produce the arrangement on a planar plate of heat sink material, although in order to provide sufficient mass with an adequate surface area a relatively large plate would be called for.

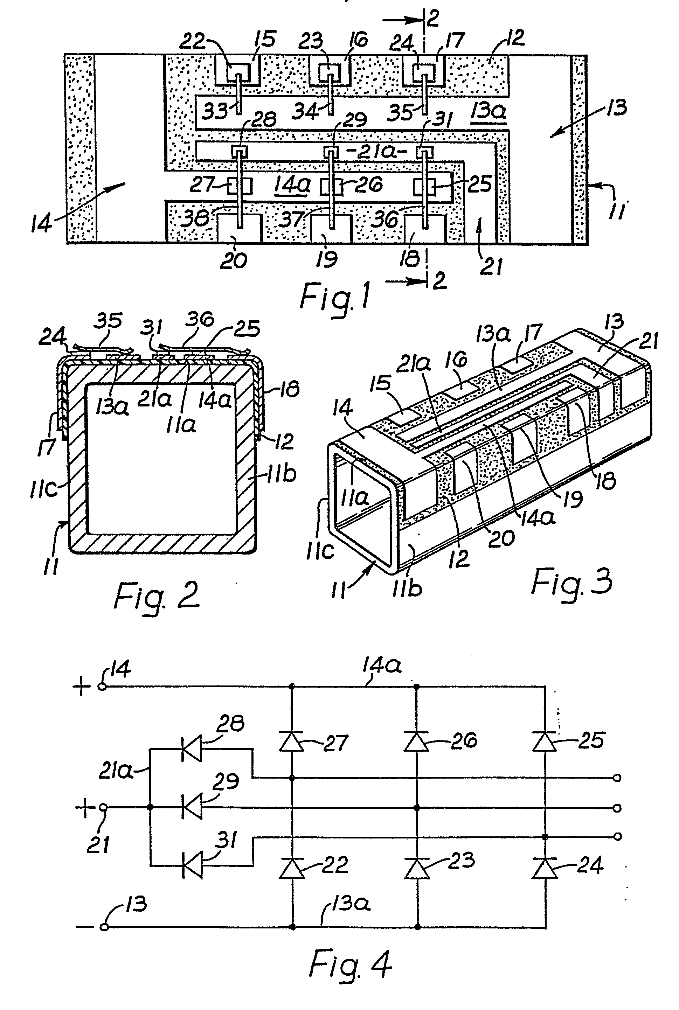

During use of the assembly illustrated in Figures 1 to 3 the assembly will be mounted such that a flow of cooling air, or other cooling medium passes through the central passage of the member 11.

CLAIMS:

1. A three phase full wave rectifier assembly characterised in that the six semi-conductor diodes (22-27) from which the full wave rectified output is obtained in use, are all supported on, and are in heat exchange relationship with, a single common heat sink member (11).

2. A rectifier assembly as claimed in claim 1 characterised in that first and second conductive areas (14a, 13a) are provided on said heat sink member (11), said areas being electrically isolated from each other, the diodes (25, 26, 27) of a first set of three of said six diodes each having the same one of its two terminals electrically connected to said first conductive area (14a) and the diodes (22, 23, 24) of a second set, comprising the remaining three of said six diodes, each having their other terminal electrically connected to said second area (13a).

3. A rectifier assembly as claimed in claim 2, characterised in that said member (11) is provided with third, fourth and fifth conductive areas (15, 16, 17) electrically isolated from each other and from said first and second conductive areas (14a, 13a) said diodes (25, 26, 27) of said first set are positioned on said first conductive area (14a) and have their said one terminals conductively bonded directly to said first conductive area (14a) and said diodes (22, 23, 24) of said second set are each positioned on a respective one of said third, fourth and fifth conductive areas (15, 16, 17) with their one terminal conductively bonded directly thereto, said other terminals of said diodes (22, 23, 24) of said second set being electrically connected by way of respective conductive links (33, 34, 35) to said second conductive area (13a) and, in use, the three phases of the supply to be rectified are applied respectively to the other terminal of a first diode (27) of said first set and said third area (15), the other terminal of a second diode (26) of said first set and the fourth area (16) and to the other terminal of the third diode (25) of said first set and the fifth area (17) whereby a rectified output appears across said first and second areas (14a, 13a).

4.    A rectifier assembly as claimed in claim 2, characterised in that said diodes (25, 26, 27) of said first set are arranged on said first conductive area (14a) with their said one terminals directly bonded thereto, said diodes (22, 23, 24) of said second set are arranged on said second conductive area (13a), with their said other terminals bonded directly thereto and, in use, the three phases of the supply to be rectified are applied respectively to the other terminal of a first diode (27) of said first set and the one terminal of a first diode (22) of said second set, to the other terminal of a second diode (26) of said first set and the one terminal of a second diode (23) of said second set, and to the other terminal of the third diode (25) of said first set and the one terminal of the third diode (24) of the second set, whereby a rectified output appears across said first and second conductive areas (14a, 13a).

5.    A rectifier assembly as claimed in claim 3 or claim 4 characterised in that the heat sink member (11) is provided with a further conductive area (21a) and said member (11) supports and is in heat exchange relationship with a third set of three diodes (28, 29, 31), the diodes (28, 29, 31) of said third set each having a common one of their two terminals electrically connected to said further conductive area (21a).

6. A rectifier assembly as claimed in claim 5, characterised in that said diodes (28, 29, 31) of said third set are arranged on said further area (21a) and have their said one terminals bonded directly to said further area, the other terminals of the diodes (28, 29, 31) of the third set, in use, having respectively phases of the supply being rectified by said first and second sets of diodes (22-24 and 25-27) applied thereto.

7. A rectifier assembly as claimed in any one of claims 1 to 6 characterised in that said heat sink member (11) is formed from electrically insulating material and said conductive areas (13a, 14a, 15, 16, 17, 21a) are layers of conductive material supported by said member (11).

8. A rectifier assembly as claimed in any one of claims 1 to 6 characterised in that said heat sink member (11) is formed from electrically conductive material and carries a layer (12) of electrically insulating material on which said conductive areas (13a, 14a, 15, 16, 17, 21a) are provided, said areas being layers of conductive material on said layer (12) of insulating material and said layers being supported by said member (11).

9. A rectifier assembly as claimed in any one of claims 1 to 6 characterised in that said heat sink member (11) is formed from electrically conductive material and an exposed surface region of said member (11) defines one of said conductive areas 13a, 14a, 15, 16, 17 21a), the other conductive areas being defined by layers of conductive material on a layer (12) of insulating material carried by said member (11), said layers being supported by said member (11).

10. A rectifier assembly as claimed in any one of the preceding claims characterised in that said layers of conductive material are provided on said member by a printed circuit technique.

11.    A rectifier assembly as claimed in any one of the preceding claims characterised in that said heat sink member (11) is tubular and said conductive areas (13a, 14a, 15, 16, 17, 21a) are on the exterior of the member.

0047099

1/1

Fig.1

Fig. 2

Fig. 3

Fig. 4